# DEMANDE DE BREVET EUROPEEN

(11) **EP 4 411 735 A1**
(43) Date de publication de la demande: **07.08.2024**
(21) Numéro de dépôt: 24153361.1
(22) Date de dépôt: 23.01.2024
(51) Int. Cl.: G11C 13/00, G11C 29/42, G06F 11/10, G06F 12/02, G06F 3/06

(54) **PROCÉDÉ D'ÉMULATION D'UNE MÉMOIRE EEPROM**

(30) Priorité: 02.02.2023 FR 2301000
(71) Demandeur: STMicroelectronics International N.V., 1228 Plan-les-Ouates, Geneva (CH)
(72) Inventeur: BENHAMMADI, Jawad, 38800 PONT DE CLAIX (FR)
(74) Mandataire: Thibon, Laurent

(57) **Abrégé**

La présente description concerne un procédé d'émulation d'une mémoire EEPROM dans une mémoire à changement de phase (104) d'un circuit intégrant un microprocesseur, le procédé comprenant les étapes suivantes : définir une granularité d'écriture dans des lignes de la mémoire à changement de phase en fonction de la taille de paquets de données à écrire (EEelement1, EEelement2, EEelementS) ; associer à chaque paquet de données, un code premier correcteur d'erreur (ECC1, ECC2, ECC3) calculé par un programme (SW) exécuté par ledit microprocesseur ; et stocker les codes correcteurs d'erreur des paquets de données dans la même ligne que ces derniers.

## Description

### Domaine technique

La présente description concerne de façon générale les procédés d'émulation de mémoire EEPROM et les circuits mémoires mettant en oeuvre ces procédés.

### Technique antérieure

De nombreuses applications requièrent un stockage de données non volatile pendant leur utilisation. Les mémoires de type non-volatiles, effaçables électriquement et programmables (Electrically-Erasable Programmable Read-Only Memory en anglais, EEPROM), peuvent être utilisées à cet effet. Ces mémoires EEPROM sont souvent externes aux circuits intégrés qui les utilisent.

On a déjà proposé d'émuler le fonctionnement d'une mémoire EEPROM dans une mémoire flash intégrée à un système sur puce (System on chip). Ces solutions sont dédiées à des mémoires flash et non transposables à d'autres technologies de mémoires.

### Résumé de l'invention

Il existe un besoin d'obtenir un dispositif intégrant une mémoire fonctionnant de manière similaire à une mémoire EEPROM qui soit compatible avec une autre technologie de mémoire qu'une mémoire flash. Plus particulièrement, il existe un besoin d'une solution pour émuler une mémoire EEPROM dans une mémoire à changement de phase.

Un mode de réalisation prévoit un procédé d'émulation d'une mémoire EEPROM dans une mémoire à changement de phase d'un circuit intégrant un microprocesseur, le procédé comprenant les étapes suivantes :
- définir une granularité d'écriture dans des lignes de la mémoire à changement de phase en fonction de la taille de paquets de données à écrire ;
- associer à chaque paquet de données, un code premier correcteur d'erreur calculé par un programme exécuté par ledit microprocesseur ; et
- stocker les codes correcteurs d'erreur des paquets de données dans la même ligne que ces derniers.

Selon un mode de réalisation, une ligne de la mémoire à changement de phase a la capacité de stocker au moins deux paquets de données associés à leurs premiers codes correcteurs d'erreur.

Selon un mode de réalisation, chaque ligne de la mémoire à changement de phase comporte une zone de données et une zone de stockage d'un deuxième code correcteur d'erreur calculé par un opérateur matériel pour la ligne correspondante, le stockage dudit deuxième code correcteur d'erreur étant désactivé lorsque la ligne est utilisée en émulation EEPROM.

Selon un mode de réalisation, les paquets des données et leurs premiers codes correcteurs d'erreur sont stockés dans ladite zone de de données.

Selon un mode de réalisation, chaque premier code correcteur d'erreur est écrit à la suite du paquet de données auquel il correspond.

Selon un mode de réalisation, les paquets de données et leurs premiers codes correcteur d'erreur respectifs sont écrits à la suite les uns des autres.

Selon un mode de réalisation, la granularité d'écriture dépend d'un paramètre modifiable par un utilisateur.

Un mode de réalisation prévoit un circuit intégré, comportant une mémoire à changement de phase et un microprocesseur, configuré pour mettre en oeuvre un tel procédé.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente un exemple de circuit intégré du type auquel s'appliquent les modes de réalisation décrits ;
la figure 2 illustre la mise en oeuvre d'un exemple de procédé d'émulation usuel d'une mémoire EEPROM dans une mémoire à changement de phase ;
la figure 3 illustre la mise en oeuvre d'un procédé d'émulation d'une mémoire EEPROM selon un mode de réalisation ; et
la figure 4 illustre la mise en oeuvre d'un procédé d'émulation d'une mémoire EEPROM selon un autre mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

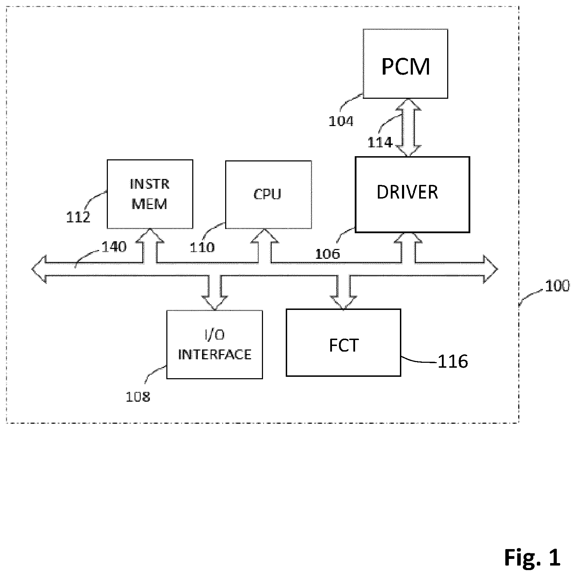

La figure 1 représente un exemple de circuit intégré du type auquel s'appliquent les modes de réalisation décrits.

Plus précisément, la figure 1 représente un exemple de dispositif en circuit intégré 100 intégrant une mémoire à changement de phase 104 (PCM). Le dispositif 100 comprend une mémoire à changement de phase 104 (PCM) capable de communication, via un bus de communication 114, avec un circuit de pilotage 106 (DRIVER) configuré pour écrire ou lire des données dans ou depuis la mémoire 102. Le circuit de pilotage 106 comprend par exemple un circuit matériel dédié qui, lorsqu'il est activé, est configuré pour calculer un code correcteur d'erreur (ECC) lors de l'écriture de chaque élément dans la mémoire 102.

Le dispositif 100 comprend en outre, par exemple, une unité de traitement 110 (CPU) comprenant un ou plusieurs processeurs sous contrôle d'instructions stockées dans une mémoire d'instructions 112 (INSTR MEM). La mémoire d'instruction 112 est par exemple de type à accès aléatoire (en anglais Random Access Memory, RAM). L'unité de traitement 110 et la mémoire 112 communiquent, par exemple, via un bus système 140 (de données, d'adresses et de commande). La mémoire 102 est reliée au bus système 140 par l'intermédiaire du circuit de pilotage 106 et du bus de communication 114. Le dispositif 100 comprend en outre une interface d'entrée/sortie 108 (I/O INTERFACE) reliée au bus système 140 pour communiquer avec l'extérieur.

Le dispositif 100 peut intégrer d'autres circuits mettant en oeuvre d'autres fonctions (par exemple, une ou plusieurs mémoires volatiles et/ou non-volatiles, d'autres unités de traitement), symbolisées par un bloc 116 (FCT) en figure 1.

Les modes de réalisation décrits prévoient d'émuler un fonctionnement de mémoire de type EEPROM dans la mémoire à changement de phase 104 du dispositif 100. En d'autres termes, une partie de la mémoire à changement de phase du circuit intégré 100 est allouée au stockage de données en émulant un fonctionnement de type EEPROM.

L'émulation d'un fonctionnement de type EEPROM permet notamment de rendre le dispositif 100 compatible avec des applications ou programmes conçus pour fonctionner avec des mémoires EEPROM sans avoir à les adapter à la nature de la mémoire à changement de phase intégrée dans le dispositif et de tirer profit d'une technologie de mémoire (les mémoires à changement de phase) moins onéreuse que la technologie EEPROM. En particulier, cela permet de faire fonctionner des applications conçues pour un fonctionnement avec une mémoire EEPROM avec un circuit intégrant une mémoire à changement de phase et d'éviter le recours à une mémoire externe.

Parmi les critères que doit respecter l'émulation d'un fonctionnement de mémoire EEPROM, on notera un besoin de respecter la granularité d'écriture, c'est-à-dire la taille des paquets de données EEPROM prévus par l'application. Typiquement, la taille des mots est d'un octet ou de deux octets et ces mots sont regroupés (encapsulés) dans des paquets ou éléments de quatre, six ou huit octets. Par exemple, la granularité d'écriture dépend de la taille des lignes de mémoire EEPROM avec laquelle l'application est prévue pour fonctionner.

Parmi les caractéristiques d'une mémoire à changement de phase, on notera le fait que celle-ci peut être écrite avec une granularité allant d'un octet à la taille d'une ligne mémoire, soit généralement seize octets, voire plus. Le circuit 106 est donc capable, en fonction de la taille de la donnée à écrire, de n'adresser qu'une partie d'une ligne.

Comme dans toute écriture mémoire, il est nécessaire d'associer, à chaque écriture de données, un code correcteur d'erreur, stocké dans la même ligne de la mémoire. Dans une mémoire à changement de phase, ce code correcteur d'erreur est calculé par le circuit 106 de façon matérielle, typiquement, par un processus combinatoire. Par ailleurs, on cherche à optimiser le cyclage, c'est-à-dire le nombre d'opérations d'écriture dans la mesure où cela conditionne la durée de vie de la mémoire.

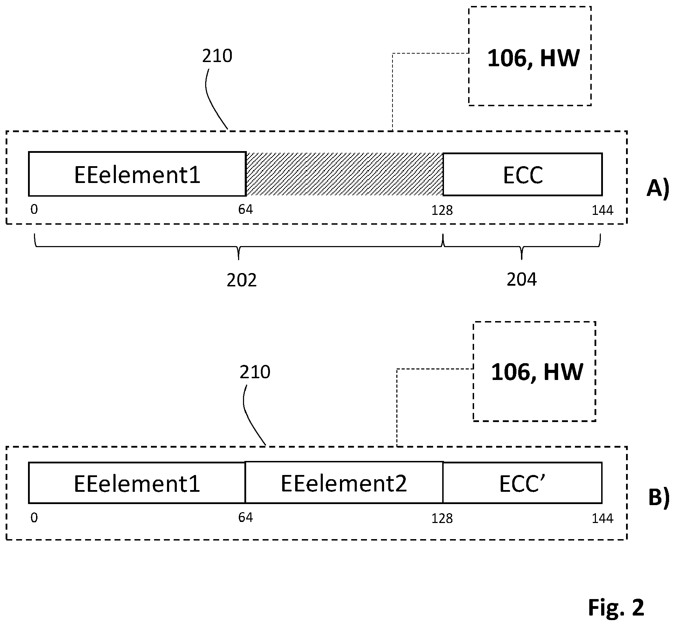

La figure 2 illustre la mise en oeuvre d'un exemple de procédé d'émulation d'une mémoire EEPROM dans une mémoire à changement de phase.

L'exemple de la figure 2, illustre plus particulièrement le contenu d'une ligne d'une mémoire à changement de phase à l'issue de deux étapes A) et B) d'écriture d'éléments ou paquets EEPROM. Bien qu'une seule ligne 210 soit représentée, la mémoire 102 comprend plusieurs dizaines, centaines ou milliers de lignes dans tout ou partie desquelles le procédé d'écriture est implémenté. Dans l'exemple représenté, chaque ligne de la mémoire à changement de phase comporte une zone de données 202 de 128 bits (16 octets) et une zone de 16 bits (2 octets) de stockage du code correcteur d'erreur de cette ligne de donnée. Le nombre d'octets écrits simultanément dans la zone de donnée 202 est configurable au niveau du circuit 106 par un ou plusieurs octets de configuration ou d'option utilisateur (User Option Bytes).

Dans l'exemple de la figure 2, on suppose que l'on souhaite émuler, dans la mémoire 102, une écriture de paquets de données de type EEPROM de 64 bits. La zone de donnée 202 est donc configurée pour écrire des sections de 8 octets.

L'étape A) illustre l'écriture d'un premier élément EEelement1 dans les 64 premiers bits de la zone de données 202 par l'intermédiaire du circuit de pilotage 106. Le code correcteur d'erreur ECC associé au contenu de zone de données 202 (élément EElement1 et contenu des 64 bits suivants) est calculé par le circuit 106 et stocké dans la zone 204. A l'issue de l'étape A, la moitié (dans cet exemple) de la zone de données 202 est inutilisée.

Une solution serait de prévoir une émulation de sorte à allouer une ligne 210 de la mémoire 102 à chaque paquet de données EEPROM. Toutefois, en raison de la différence de taille entre les lignes de la mémoire 102 et les éléments EPPROM, on perdrait alors trop d'espace mémoire. On aurait aussi pu penser dimensionner la mémoire à changement de phase en fonction de la taille des éléments EEPROM. Toutefois, cela ne permettrait pas d'émuler une mémoire EEPROM dans des circuits existants. De plus, la taille des élément EEPROM est susceptible de varier en fonction de l'application exécutée et pour laquelle on souhaite émuler un fonctionnement EEPROM.

La solution illustrée par la figure 2 (étape B)) consiste à utiliser le reste de la zone de données 202 pour y stocker un deuxième élément EEPROM EEelement2. Ainsi, dans l'exemple d'éléments de 8 octets et d'une zone de données 202 de 16 octets, on exploite l'intégralité de la zone d'écriture. Le code correcteur d'erreur de la zone 202 doit cependant être recalculé et un nouveau code ECC' est écrit dans la zone 204 de la ligne en remplaçant le code correcteur d'erreur ECC précédent.

Le fait de devoir réécrire le code correcteur d'erreur dans la même zone 204 lorsque qu'un deuxième élément EEPROM sont écrits dans une même ligne diminue par deux le nombre de cyclages possibles de la zone de données 204 de mémoire à changement de phase. Cette perte de durée de vie de la mémoire est d'autant plus importante que la différence entre la taille des paquets EEPROIM et la taille de la ligne 210 est importante. De plus, le calcul des codes correcteur d'erreur étant réalisé par un circuit matériel dédié, il est complexe d'en modifier le fonctionnement une fois mis en production pour, si besoin, l'adapter au fonctionnement EEPORM souhaité (nombre d'erreurs détectables et nombre d'erreur corrigeables).

Selon les modes de réalisation décrits, on prévoit, lorsqu'une mémoire EEPROM doit être émulée dans une mémoire à changement de phase, de calculer de façon logicielle, les codes correcteurs d'erreur des éléments EEPROM à stocker dans la mémoire à changement de phase et de stocker chaque couple élément EEPROM et code correcteur d'erreur l'un à la suite de l'autre dans la zone de données d'une ligne de la mémoire à changement de phase. Ainsi, on peut tirer pleinement profit de la granularité configurable d'écriture de la mémoire à changement de phase pour, en fonction de l'application, faire correspondre cette granularité à la taille des enregistrements (élément + code) dont on a besoin en émulation EEPROM. De plus, grâce à la granularité d'écriture configurable dans la mémoire à changement de phase, l'écriture des codes correcteurs d'erreur dans la zone de donnée 202, une fois le paquet EEPROM écrit n'est pas un problème.

En procédant de la sorte, le code correcteur d'erreur matériel de la zone 204 n'est plus utile et son stockage peut être désactivé dans la partie de la mémoire à changement de phase allouée à l'émulation EEPROM. Cela permet de ne pas nuire à la durée de vie de la mémoire à changement de phase. Le prix à payer est une réduction de la taille totale disponible d'une ligne de la mémoire à changement de phase en mode d'émulation EEPROM, correspondant la zone 204 qui ne peut pas être utilisée en mode EEPROM. En effet, de par la structure du circuit, cette zone est réservée au code correcteur d'erreur calculé de façon matérielle.

La taille de la partie (nombre de lignes) de la mémoire à changement de phase allouée au stockage de données "EEPROM" dépend de l'application et de la capacité mémoire que l'on souhaite réserver à du code programme dans le reste de la mémoire à changement de phase et à des données dans la partie émulée. Cette configuration est effectuée en utilisant les octets de configuration usuels ou octets d'option utilisateur (User Option Bytes) .

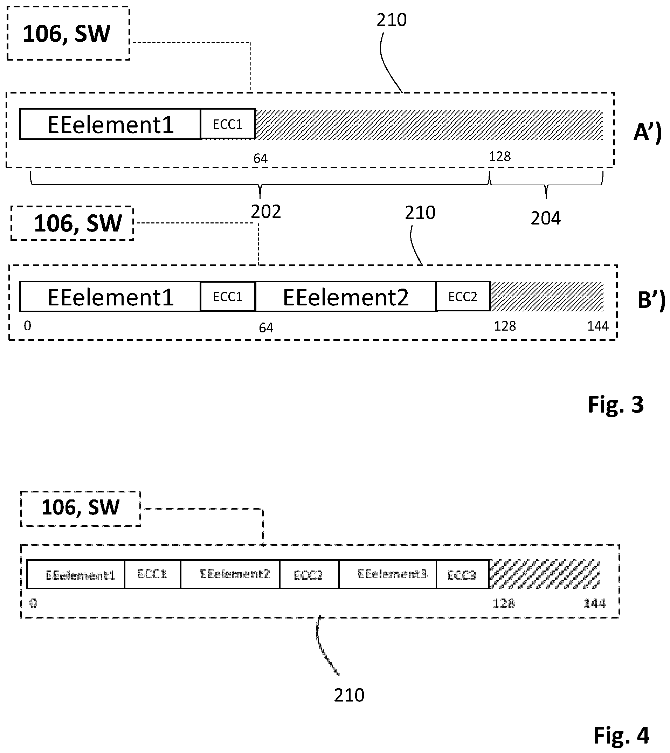

La figure 3 illustre la mise en oeuvre d'un procédé d'émulation d'une mémoire EEPROM selon un mode de réalisation.

L'exemple de la figure 3 représente plus particulièrement deux étapes A') et B') d'écriture d'éléments de type EEPROM dans une même ligne de la mémoire à changement de phase 104. Chaque ligne de la mémoire à changement de phase comporte, comme en figure 2, une zone de données 202 et une zone 204 adjacente dédiée au code correcteur d'erreur matériel. Dans l'exemple de la figure 3, la zone 204 n'est néanmoins plus écrite dans la partie de la mémoire affectée à l'émulation EEPROM. Pour cela, les octets de configuration utilisateur destinés au circuit 106 comportent un ou plusieurs bits conditionnant l'enregistrement du code calculé dans la zone 204. Il est ainsi possible d'empêcher l'écriture du code correcteur d'erreur pour les lignes de la mémoire à changement de phase allouées à l'émulation EEPROM. Comme mentionné précédemment, cela permet de profiter de la granularité configurable des enregistrements (élément + code correcteur associé) sans nuire à la durée de vie de la mémoire à changement de phase. Le cas échéant, les octets de configuration désactivent également l'opérateur matériel de code correcteur d'erreur.

En figure 3, on suppose le besoin de stocker des enregistrements (éléments EEPROM + code correcteur) de 64 bits, soit jusqu'à deux éléments EEPROM par ligne 210.

Dans une étape A'), un premier élément EEPROM EEelement1 est écrit sur les 48 premiers bits de la zone d'écriture 202 par l'intermédiaire du circuit de pilotage 106. Un code correcteur d'erreur ECC1 associé à l'écriture du premier élément EEPROM EEelement1 est calculé par un programme exécutable (SW) par un microprocesseur, par exemple l'unité de traitement 110 ou un microprocesseur du circuit de pilotage 106, puis écrit dans la zone 202 de la ligne de la mémoire 102 à la suite du premier élément EEPROM EEelement1. Le code correcteur d'erreur ECC1 est par exemple d'une taille de 16 bits.

Dans une étape B'), un deuxième élément EEPROM EEelement2 de 48 bits est écrit dans les 64 bits suivants et adjacents à l'espace où le code correcteur d'erreur ECC1 est écrit. Un code correcteur d'erreur ECC2 associé à l'écriture du deuxième élément EEPROM EEelement2 est calculé par le programme exécutable SW par microprocesseur puis est écrit dans la zone 202 de la ligne à la suite du code correcteur d'erreur ECC1 du deuxième élément EEPROM EEelement2.

La figure 4 illustre la mise en oeuvre d'un procédé d'émulation d'une mémoire EEPROM selon un autre mode de réalisation.

Par rapport au mode de réalisation de la figure 3, on suppose que l'application requérant l'émulation d'une mémoire EEPROM a besoin de stocker des paquets ou éléments plus petits, par exemple de 4 octets (32 bits). Leur code correcteur d'erreur est alors également plus petit (pour des caractéristiques identiques en termes de nombre d'erreurs détectables et corrigeables), par exemple de 12 bits. Trois enregistrements (élément EEPROM + code correcteur) peuvent alors être stockés par ligne 210 de la mémoire à changement de phase. Le gain en termes de cyclage par rapport à la solution de la figure 2, en évitant de réécrire trois fois la zone 204, est alors encore plus important qu'avec le mode de réalisation de la figure 3. Les trois éléments EEPROM EEelement1, EEelement2 et EEelement3 sont écrits successivement les uns à la suite des autres avec interposition de leurs codes correcteurs d'erreur respectifs ECC1, ECC2, ECC3, calculés de façon logicielle.

Plus généralement, le nombre d'éléments EEPROM pouvant être stocké par ligne dépend de la taille requise pour les enregistrements EEPROM et de la taille de la ligne. La solution proposée apporte un gain en termes de cyclage dès que l'on peut stocker au moins deux éléments par ligne de mémoire à changement de phase.

Un autre avantage est que l'utilisation du programme exécutable par microprocesseur SW à la place du circuit matériel dédié HW usuel pour le calcul des codes correcteur d'erreur offre une souplesse en termes de paramétrage du code correcteur d'erreur (nombre d'erreurs détectables et nombre d'erreurs corrigeables).

Un autre avantage de la solution décrite est que sa mise en oeuvre de requiert pas de modification matérielle ou structurelle du circuit intégrant la mémoire à changement de phase. Ainsi, elle permet d'émuler un fonctionnement de mémoire EEPROM dans des circuits intégrés existants possédant une mémoire à changement de phase.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les tailles des éléments EEPROM (de préférence, 4, 6 ou 8 octets), des codes correcteurs d'erreur calculés de façon logiciels (de préférence, respectivement 8, 12 ou 16 bits pour des paquets de données de 32, 48 ou 64 bits), des zones de données 202 (de préférence 128 ou 256 bits) des lignes de mémoire à changement de phase, et de la partie (nombre de lignes) de cette mémoire allouée à l'émulation EEPROM dépend de l'application.

Enfin, la mise en oeuvre pratique des modes de réalisation et variantes décrits est à la portée de la personne du métier à partir des indications fonctionnelles données ci-dessus. En particulier, pour ce qui est de l'agencement des éléments EEPROM et de leurs codes correcteur d'erreur associés dans les lignes de la mémoire 102, il est envisageable que tous les codes correcteurs d'erreur soient regroupés en fin de zone de données 202. La personne de l'art pourra également envisager un ou des espaces libres entre un des éléments EEPROM et le code correcteur d'erreur associé. Toutefois, un avantage d'un stockage de chaque code correcteur d'erreur à la suite du paquet auquel il est associé est que cela simplifie l'adressage dans la mémoire en évitant, notamment en lecture, de devoir adresser les codes correcteurs d'erreur séparément des paquets auxquels ils correspondent.

## Revendications

1. Procédé d'émulation d'une mémoire EEPROM dans une mémoire à changement de phase (104) d'un circuit intégrant un microprocesseur, le procédé comprenant les étapes suivantes :
- définir une granularité d'écriture dans des lignes de la mémoire à changement de phase en fonction de la taille de paquets de données à écrire (EEelement1, EEelement2, EEelement3) ;
- associer à chaque paquet de données, un code premier correcteur d'erreur (ECC1, ECC2, ECC3) calculé par un programme (SW) exécuté par ledit microprocesseur ; et
- stocker plusieurs paquets de données et leurs codes correcteurs d'erreur respectifs dans une même ligne de la mémoire.

2. Procédé selon la revendication 1, dans lequel une ligne (210) de la mémoire à changement de phase a la capacité de stocker au moins deux paquets de données associés à leurs premiers codes correcteurs d'erreur.

3. Procédé selon la revendication 1 ou 2, dans lequel chaque ligne de la mémoire à changement de phase comporte une zone (202) de données et une zone (204) de stockage d'un deuxième code correcteur d'erreur calculé par un opérateur matériel pour la ligne correspondante, le stockage dudit deuxième code correcteur d'erreur étant désactivé lorsque la ligne est utilisée en émulation EEPROM.

4. Procédé selon la revendication 3, dans lequel les paquets des données et leurs premiers codes correcteurs d'erreur sont stockés dans ladite zone de de données.

5. Procédé selon l'une quelconque des revendications 1 à 4, dans lequel chaque premier code correcteur d'erreur (ECC) est écrit à la suite du paquet de données (EEelement1, EEelement2, EEelement3) auquel il correspond.

6. Procédé selon l'une quelconque des revendications 1 à 5, dans lequel les paquets de données (EEelement1, EEelement2, EEelement3) et leurs premiers codes correcteur d'erreur (ECC1, ECC2, ECC3) respectifs sont écrits à la suite les uns des autres.

7. Procédé selon l'une quelconque des revendications 1 à 6, dans lequel la granularité d'écriture dépend d'un paramètre modifiable par un utilisateur.

8. Circuit intégré, comportant une mémoire à changement de phase (102) et un microprocesseur, configuré pour mettre en oeuvre le procédé selon l'une quelconque des revendications 1 à 7.
